(19) **Europäisches Patentamt**

**European Patent Office**

**Office européen des brevets**

(11) **EP 1 095 450 B1**

(12) **EUROPÄISCHE PATENTSCHRIFT**

(45) Veröffentlichungstag und Bekanntmachung des Hinweises auf die Patenterteilung:
**29.05.2002 Patentblatt 2002/22**

(21) Anmeldenummer: **99941398.2**

(22) Anmeldetag: **28.06.1999**

(51) Int Cl.$^7$: **H03H 17/06**

(86) Internationale Anmeldenummer:
**PCT/DE99/01878**

(87) Internationale Veröffentlichungsnummer:
**WO 00/02311 (13.01.2000 Gazette 2000/02)**

(54) **NICHTREKURSIVES DIGITALES FILTER UND VERFAHREN ZUR BERECHNUNG DER KOEFFIZIENTEN DIESES FILTERS**

NON RECURSIVE DIGITAL FILTER AND METHOD FOR CALCULATING THE COEFFICIENTS OF SUCH A FILTER

FILTRE NUMERIQUE NON RECURSIF ET PROCEDE DE CALCUL DES COEFFICIENTS DE CE FILTRE

(84) Benannte Vertragsstaaten:
**AT DE FR GB IT**

(30) Priorität: **30.06.1998 DE 19829289**

(43) Veröffentlichungstag der Anmeldung:
**02.05.2001 Patentblatt 2001/18**

(73) Patentinhaber: **Infineon Technologies AG**
**81669 München (DE)**

(72) Erfinder: **SCHÖLLHORN, Peter**
**D-82008 Unterhaching (DE)**

(74) Vertreter: **Barth, Stephan Manuel, Dr.**
**Reinhard-Skuhra-Weise & Partner Gbr,**
**Patentanwälte**
**Friedrichstrasse 31**
**80801 München (DE)**

(56) Entgegenhaltungen:
**EP-A- 0 401 562**

- **SANGIL PARK: "REAL-TIME PITCH (FREQUENCY) SHIFTING TECHNIQUES" PROCEEDINGS OF THE INTERNATIONAL CONFERENCE ON CONSUMER ELECTRONICS. (ICCE),US,NEW YORK, IEEE, Bd. CONF. 10, Juni 1991 (1991-06), Seite 296-297 XP000289043 ISBN: 0-7803-0001-7**
- **HSIEH S. HOU ET AL: "CUBIC SPLINES FOR IMAGE INTERPOLATION AND DIGITAL FILTERING" IEEE TRANSACTIONS ON ACOUSTICS, SPEECH AND SIGNAL PROCESSING., Bd. 26, Nr. 6, Dezember 1978 (1978-12), Seiten 508-517, XP002123955 IEEE INC. NEW YORK., US**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 095 450 B1

**Beschreibung**

Die vorliegende Erfindung betrifft ein nichtrekursives digitales Filter und ein Verfahren zur Berechnung der Koeffizienten dieses Filters.

Zahlreiche Produkte enthalten Filter (z.B. Klangsteller eines Fernsehgerätes oder Autoradios, Frequenzweichen von Lautsprechersystemen), deren Charakteristik in Frequenzrichtung verschiebbar sein muß.

Werden diese Filter durch digitale Signalverarbeitung realisiert, so werden üblicherweise - trotz einiger Nachteile - rekursive Filter eingesetzt. Dieser Filtertyp ist dadurch gekennzeichnet, daß er nur wenige Parameter (Koeffizienten) besitzt, die verändert werden müssen, um den Frequenzgang des Filters (z.B. zur Variation der Grenzfrequenz) zu.verschieben, ohne die Abtastfrequenz des Filters verändern zu müssen.

In "Zeitdiskrete Signalverarbeitung" von A. V. Oppenheim und R. W. Schafer, Oldenburg-Verlag, München, 1992, S. 152f wird auf die Möglichkeit hingewiesen, durch Verändern der Abtastfrequenz den Frequenzgang eines digitalen Filters zu verschieben. Dieser Ansatz erfordert in der Regel allerdings Antialiasfilter oder Dezimationsfilter mit variabler Grenzfrequenz, d.h. das Problem wird nur verlagert.

Hierbei ist aus der EP-A 0 401 562 bereits ein nichtrekursives digitales Filter mit einer Filterberechnungseinheit, die aus einem Eingangssignal ein -Ausgangssignal berechnet, wobei die Filterberechnungseinheit mit einer Koeffizientenberechnungseinheit verbunden ist, die die Koeffizienten für die Filterberechnungseinheit liefert, und die Koeffizientenberechnungseinheit mit einem Koeffizientenspeicher, einer Bedienerschnittstelle und einer Steuereinheit verbunden ist, bekannt.

Weiter ist aus dem Aufsatz von Sangil Park, "REAL-TIME PITCH (FREQUENCY) SHIFTING TECHNIQUES" in Proceedings of the international conference on consumer electronics (ICCE), New York, USA, IEEE, Bd. Conf. 10, Juni 1991, Seite 296-297 ein Verfahren zur Verschiebung der Frequenz/Tonhöhe eines Signals in Echtzeit bekannt, bei dem im Verfahren das Signal mit einer zweiten Abtastrate abgetastet wird, deren Verhältnis zur ursprünglichen Abtastrate dem Verhältnis von ursprünglicher Tonhöhe (Frequenz) zu angestrebter Tonhöhe (Frequenz) entsprechend gewählt wird, und bei dem die Ausgangsabtastwerte wieder mit der ursprünglichen Abtastrate ausgegeben werden.

Ausgehend von diesem Stand der Technik ist es daher Aufgabe der vorliegenden Erfindung, ein nichtrekursives digitales Filter zu schaffen, dessen Frequenzgang bei konstanter Abtastfrequenz einfach verschiebbar ist. Dazu soll die vorliegende Erfindung auch das erforderliche Berechnungsverfahren für die Koeffizienten dieses Filters zur Verfügung stellen.

Erfindungsgemäß wird diese Aufgabe durch die in den Ansprüchen 1 und 2 beschriebenen Verfahren gelöst.

Die unteransprüche zeigen jeweils vorteilhafte Ausführungsformen der Erfindung.

Aus der Systemtheorie (Fouriertransformation) ist bekannt, daß einer Verschiebung des Frequenzgangs eines Filters eine entgegengesetzte Verschiebung der Impulsantwort des Filters entspricht. Die Koeffizienten eines digitalen nichtrekursiven Filters (Prototyp der Frequenzcharakteristik) stellen Abtastwerte einer solchen Impulsantwort dar. Aus diesen Abtastwerten kann nun unter Vorgabe einer Abtastfrequenz fa1 prinzipiell der zeitkontinuierliche Verlauf der Impulsantwort berechnet werden. Durch Abtasten dieses zeitkontinuierlichen Signals mit einer anderen Abtastfrequenz fa2 erhält man wieder Koeffizienten eines nichtrekursiven digitalen Filters. Wird dieses Filter dann mit der Abtastfrequenz fa1 betrieben, erhält man die gewünschte verschobene Frequenz-Charakteristik. Wird dabei fa2 größer als fa1 gewählt, so wird die Frequenzcharakteristik des Filters gestaucht, für fa2 kleiner als fa1 wird die Charakteristik gedehnt. Das eigentliche Problem besteht dabei in der Interpolation der neuen Koeffizienten aus den Koeffizienten des Prototypen. Diese Interpolation entspricht der Kombination aus Rekonstruktion der zeitkontinuierlichen Impulsantwort und deren Abtastung mit fa2. Die Realisierungsdetails werden im folgenden im einzelnen erläutert:

H(f) sei die Fourier - Transformierte der Impulsantwort h(t) eines linearen Systems, kurz: h(t) <=> H(f). Dann gilt: h(a*t) 1/a*H(f/a), d.h. wird die Impulsantwort h(t) gedehnt (a < 1), dann wird die Transformierte H(f) gestaucht und umgekehrt. Außerdem wird die Transformierte H(f) mit dem Faktor 1/a "verstärkt".

Diese Eigenschaft bleibt prinzipiell auch nach der Abtastung der Impulsantwort erhalten, solange das Abtasttheorem nicht verletzt wird. Bei Verletzung des Theorems muß darauf geachtet werden, daß die gewünschte Frequenzcharakteristik H(f/a) nicht unzulässig verändert wird.

Nehmen wir an, ein digitales Filter werde bei der Abtastfrequenz fa1 betrieben und habe dann die charakteristische Frequenz (z.B. 3 dB - Grenzfrequenz eines Tiefpasses) fc1. Wird dasselbe Filter nun bei der Abtastfrequenz fa2 betrieben, so ergibt sich die neue charakteristische Frequenz fc1 = fc1*(fa2/fa1).

Die Berechnung der Koeffizienten eines neuen nichtrekursiven Filters aus den Koeffizienten eines vorgegebenen nichtrekursiven Filters (im folgenden Prototyp genannt) mit dem Ziel, die charakteristische Frequenz von fc1 nach fc2 zu verschieben, geschieht folgendermaßen:

Schritt 1: Koeffizienten h1(n) des Prototyps für Abtastfrequenz fa1 berechnen
Schritt 2: Berechnen der zugehörigen zeitkontinuierlichen Impulsantwort h(t)

Schritt 3: Abtastung der Impulsantwort h(t) mit der Abtastfrequenz fa2 = (fc1/fc2)*fa1

Schritt 4: Betrieb des neuen Filters mit den Koeffizienten h2(n) bei fa1

Um dieses Verfahren in der Praxis auch unter Echtzeitbedingungen anwenden zu können, werden die Schritte 2 und 3 zusammengefaßt, d.h. die neuen Koeffizienten werden aus den Koeffizienten des Prototyps berechnet. Dabei werden die Werte der zeitkontinuierlichen Impulsantwort h(t) im Abstand 1/fa2 interpoliert. In der Praxis bieten sich u.a. Polynome zur Interpolation an. Der Grad der Polynome ist im Prinzip beliebig. In der Praxis werden aus Aufwandsgründen nur Polynome vom Grad 0 (Halteglied), vom Grad 1 (lineare Interpolation), vom Grad 2 (quadratische Interpolation) oder vom Grad 3 (kubische Interpolation) sinnvoll sein.

Besitzt der Prototyp eine konstante Gruppenlaufzeit, so kann diese i.a. besonders nützliche Eigenschaft auf das neue Filter übertragen werden, indem das zeitkontinuierliche Filter ausgehend von der zeitlichen Mitte abgetastet wird. Besitzt der Prototyp N Koeffizienten h1(n), mit n=0,1, ..., N-1, dann liegt die zeitliche Mitte von h(t) an der Stelle tm = (N-1)/2* 1/fa1. Damit muß h(t) an den Stellen t = tm + k*1/fa2 mit k = 0, +/-1, +/-2 usw. interpoliert werden. k muß so lange inkrementiert bzw. dekrementiert werden, bis alle zur jeweiligen Interpolation verwendeten Stützwerte h1(n) den Wert Null aufweisen.

Aufgrund der Symmetrie der Impulsantwort muß im Prinzip nur eine Hälfte der Koeffizienten tatsächlich berechnet werden (k>=0).

Die Fourier-Transformation besitzt auch folgende Eigenschaft:

$$\sin(2*\Pi*f0*t)*h(t) <=> 1/(2i)*H(f-f0)-1/(2i)*H(f+f0)$$

bzw.,

$$\cos(2*\Pi*f0*t)*h(t) <=> 1/2*H(f-f0)+1/2*H(f+f0).$$

Dies gilt mit den bereits oben genannten Einschränkungen auch für abgetastete Signale und damit auch für digitale Filter, d.h. werden die Koeffizienten des Filters mit den Abtastwerten einer Sinus- oder Cosinusfunktion der Frequenz f0 multipliziert, so wird die ursprüngliche Frequenzcharakteristik um f0 verschoben (z.B. wird so aus einem Tiefpaß ein Bandpaß). Damit können durch einfache Maßnahmen die Frequenzgänge digitaler Filter auch unter Echtzeitbedingungen verschoben werden. Damit können z.B. Equalizer mit konstanter Gruppenlaufzeit (Autoradio, Fernsehgeräte, Stereoanlage, etc.) aus nichtrekursiven Filtern aufgebaut werden. Herkömmliche Equalizer sind aus rekursiven Filtern aufgebaut, die starke Laufzeitverzerrungen aufweisen.

Zwei Ausführungsformen der Erfindung werden im folgenden anhand der beigefügten Zeichnungen näher erläutert. Es zeigen:

**Figur 1** ein erfindungsgemäßes digitales Filter, bei dem alle Koeffizienten für die neue Filtercharakteristik zuerst komplett berechnet werden;

**Figur 2** ein erfindungsgemäßes Filter bei dem die Charakteristik des Filters ohne Zeitverzögerung geändert werden kann.

Bei beiden Varianten sind die festen Koeffizienten des Prototyps in einem Speicher 10 abgelegt und werden in der Regel während des Betriebs nicht verändert. Ist sichergestellt, daß die Koeffizienten niemals verändert werden, so kann ein kosteneffizienter ROM-Speicher verwendet werden, der es erlaubt, auch sehr umfangreiche Koeffizientensätze zu speichern.

Besteht die Möglichkeit, alle Koeffizienten des neuen Filters zuerst komplett zu berechnen, bevor sie zur Berechnung der Filterausgangswerte benutzt werden, so kann ein Interpolationspolynom mit einem höheren Grad verwendet werden. besitzt der Prototyp symmetrische Koeffizienten, so muß nur die Hälfte der Koeffizienten tatsächlich berechnet und gespeichert werden (sh. oben).

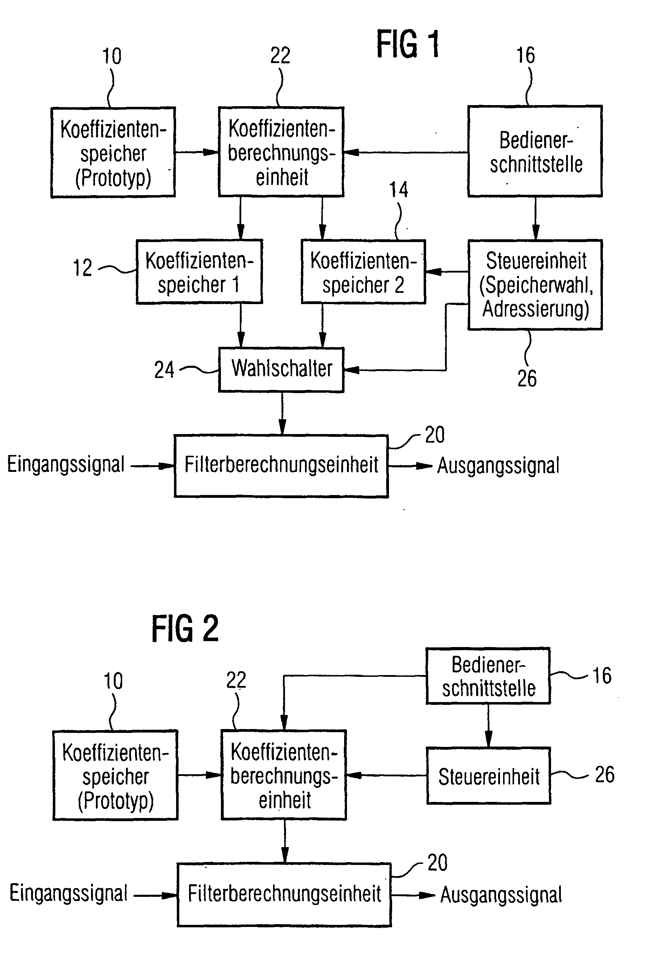

Figur 1 zeigt eine Ausführungsform eines solchen Filters, bei dem die entsprechenden Koeffizientensätze vorab berechnet und bereitgestellt werden.

Es werden zwei RAM-Speicher 12, 14 verwendet: ein Speicher 12 enthält die aktuellen Filterkoeffizienten, der zweite Speicher 14 nimmt die neu berechneten Koeffizienten auf, falls eine veränderte Charakteristik angefordert wird. Sind alle neuen Koeffizienten verfügbar, tauschen die beiden Speicher ihre Rolle. Wird bei symmetrischen, linearphasigen Filtern nur der halbe Koeffizientensatz berechnet und gespeichert, so muß diesem Umstand durch die entsprechende Berechnung der Speicheradresse Rechnung getragen werden.

Als Anwendungen kommen hier z.B. Klangsteller und Frequenzweichen in Betracht. Hier müssen immer dann neue Koeffizienten berechnet werden, wenn an der Bedienschnittstelle (Schieberegler, Drehknopf) Parameter verändert werden. Hier steht - gemessen an der Abtastfrequenz des Filters - viel Zeit zur Verfügung, um die neuen Koeffizienten "off line" zu berechnen.

Der Aufbau eines solchen Filters ist in Fig. 1 im einzelnen dargestellt. Wie bei allen digitalen Filtern wird ein Eingangssignal einer Filterberechnungseinheit 20 zugeführt, die dieses Eingangssignal in ein Ausgangssignal umrechnet. Erfindungsgemäß sind jedoch die entsprechenden Koeffizienten für die Umrechnung hier nicht in der Filterberechnungseinheit festgelegt, vielmehr werden sie der Filterberechnungseinheit von außen zugeführt. Zur Ermittlung der entsprechenden Koeffizienten dient eine Koeffizientenberechnungseinheit 22. Diese steht mit dem bereits erwähnten Koeffizientenspeicher 10 für die Koeffizienten des Filterprototyps und mit einer Bedienerschnittstelle in Verbindung. Die Koeffizientenberechnungseinheit 22 führt die berechneten Koeffizienten abwechselnd einem der beiden Koeffizientenspeicher 12, 14 zu. Diese stehen mit einem Wahlschalter 24 in Verbindung, der jeweils einen Koeffizientensatz aus dem Koeffizientenspeicher 12 oder dem Koeffizientenspeicher 14 zur Filterberechnungseinheit 20 durchschaltet. Die Steuerung des Wahlschalters erfolgt über eine Steuereinheit 26, die wiederum von der Bedienerschnittstelle 16 angesteuert wird.

Soll eine möglichst einfach Methode der Interpolation eingesetzt werden (Halteglied oder lineare Interpolation), um z.B. laufend die benötigten Koeffizienten berechnen zu können, so kann die Anzahl N der Koeffizienten des Prototypen soweit erhöht werden, bis sichergestellt ist, daß die interpolierte Impulsantwort h2(n) den Anforderungen der jeweiligen Anwendung genügt. Hier werden keine Koeffizientenspeicher benötigt. Alle Anwendungen, bei denen es notwendig ist, daß die veränderte Charakteristik des Filters sofort wirksam werden muß, benötigen diese Variante.

Figur 2 zeigt eine Ausführungsform des erfindungsgemäßen Filters, bei der eine Anpassung der Koeffizienten in Echtzeit möglich ist. Hierbei muß lediglich eine ausreichend schnelle Koeffizientenberechnungseinheit bzw. ein entsprechend vereinfachter Algorithmus für die Berechnung der Koeffizienten verwendet werden. Koeffizientenspeicher und Koeffizientenspeicherauswahl entfallen dabei.

**Patentansprüche**

1. Verfahren zur Berechnung der Koeffizienten eines nichtre kursiven, digitalen Filters zwecks Verschiebung des Frequenzgangs dieses Filters von einer charakteristischen Frequenz fc1 zu einer anderen charakteristischen Frequenz fc2, **gekennzeichnet durch** folgende Verfahrensschritte:

   a) Es werden die Koeffizienten h1(n) eines Prototyps des Filters für eine gegebene Abtastfrequenz fa1 vorgege ben oder berechnet.

   b) Es wird die zu diesem Prototypen gehörige zeitkontinuierliche Impulsantwort h(t) berechnet.

   c) Die Impulsantwort h(t) wird mit der Abtastfrequenz $fa2 = fa1 \cdot \frac{fc1}{fc2}$ abgetastet, wobei sich die Koeffizien ten h2(n) ergeben.

   d) Das Filter wird mit dem neuen Koeffizienten h2(n) bei fa1 betrieben.

2. Verfahren zur Berechnung der Koeffizienten eines nichtrekursiven, digitalen Filters zwecks Verschiebung des Frequenzgangs dieses Filters von einer charakteristischen Frequenz fc1 zu einer anderen charakteristischen Frequenz fc2, **gekennzeichnet durch** folgende Verfahrensschritte:

   a) Es werden die Koeffizienten h1(n) eines Prototyps des Filters für eine gegebene Abtastfrequenz fa1 vorgegeben oder berechnet.

   b) Aus den Koeffizienten h1(n) werden die neuen Koeffizienten h2(n) berechnet, indem die Werte der zeitkontinuierlichen Impulsantwort h(t) im Abstand 1/fa2 interpoliert werden, wobei $fa2 = fa1 \cdot \frac{fc1}{fc2}$.

   c) Das Filter wird mit dem neuen Koeffizienten h2(n) bei fa1 betrieben.

3. Verfahren nach Anspruch 2, **dadurch gekennzeichnet, daß** Polynome zur Interpolation verwendet werden.

4. Verfahren nach Anspruch 3, **dadurch gekennzeichnet, daß** lediglich Polynome vom Grad 0 bis 3 verwendet werden.

5. Verfahren nach einem der Ansprüche 2 bis 4, **dadurch gekennzeichnet, daß** das zeitkontinuierliche Filter ausgehend von der zeitlichen Mitte abgetastet wird.

6. Verfahren nach Anspruch 5, **dadurch gekennzeichnet, daß** bei einem Filter-Prototyp mit N Koeffizienten h1(n) mit n=0,1,..., N-1 an den Stellen

$$t = \frac{N-1}{2 * fa1} + \frac{k}{fa2} \ mit \ k = 0;+/-1;+/-2;...$$

interpoliert wird, wobei k so lange inkrementiert bzw. dekrementiert wird, bis alle zur jeweiligen Interpolation verwendeten Koeffizienten h1(n) den Wert 0 aufweisen.

7. Verfahren nach Anspruch 6, **dadurch gekennzeichnet, daß** nur die Koeffizienten mit k=0; +1; +2... berechnet werden, da die Koeffizienten mit negativem k den entsprechenden Koeffizienten mit positivem k entsprechen.

8. Verfahren nach einem der Ansprüche 1 bis 7, **dadurch gekennzeichnet, daß** die neuen Koeffizienten h2(n) mit den Abtastwerten einer Sinus- oder Cosinusfunktion einer Frequenz fo multipliziert werden.

## Claims

**1.** A method for calculating the coefficients of a nonrecursive digital filter for the purpose of shifting the frequency response of this filter from one characteristic frequency fc1 to another characteristic frequency fc2, which has the following method steps:

> a) the coefficients h1(n) of a prototype of the filter are prescribed or calculated for a given sampling frequency fa1.

> b) The continuous-time impulse response h(t) associated with this prototype is calculated.

> c) The impulse response h(t) is sampled at the sampling frequency fa2 = fa1 * $\frac{fc1}{fc2}$, the coefficients h2(n) being produced.

> d) The filter is operated with the new coefficient h2(n) at fa1.

**2.** A method for calculating the coefficients of a nonrecursive digital filter for the purpose of shifting the frequency response of this filter from one characteristic frequency fc1 to another characteristic frequency fc2, which has the following method steps:

> a) the coefficients h1(n) of a prototype of the filter are prescribed or calculated for a given sampling frequency fa1.

> b) The new coefficients h2(n) are calculated from the coefficients h1(n) by interpolating the values of the continuous-time impulse response h(t) at an interval 1/fa2, where $fa2 = fa1 \frac{fc1}{fc2}$.

> c) The filter is operated with the new coefficient h2(n) at fa1.

**3.** The method as claimed in claim 2, wherein polynomials are used for the interpolation.

**4.** The method as claimed in claim 3, wherein only polynomials of order 0 to 3 are used.

**5.** The method as claimed in one of claims 2 to 4, wherein the continuous-time filter is sampled starting from the temporal midpoint.

**6.** The method as claimed in claim 5, wherein, in the case of a filter prototype having N coefficients h1(n) where n=0,1,...,N-1, interpolation is performed at the points

$$t = \frac{N-1}{2*fa1} + \frac{k}{fa2} \ where \ k = 0;+/-1;+/-2,...$$

k being incremented or decremented until all the coefficients h1(n) used for the respective interpolation have the value 0.

**7.** The method as claimed in claim 6, wherein only the coefficients where k=0; +1; +2... are calculated since the coefficients with negative k correspond to the corresponding coefficients with positive k.

**8.** The method as claimed in one of claims 1 to 7, wherein the new coefficients h2(n) are multiplied by the samples of a sine or cosine function having a frequency fo.

## Revendications

**1.** Procédé de calcul des coefficients d'un filtre numérique non récursif en vue du décalage de la réponse en fréquence de ce filtre d'une fréquence caractéristique fc1 à une autre fréquence caractéristique fc2, **caractérisé par** les étapes suivantes :

> a) spécifier ou calculer les coefficients h1(n) d'un prototype du filtre pour une fréquence d'échantillonnage fa1 donnée;
> b) calculer la réponse impulsionnelle h(t) continue dans le temps associée à ce prototype;
> c) échantillonner la réponse impulsionnelle h(t) à la fréquence d'échantillonnage fa2 = fa1 * $\frac{fc1}{fc2}$, ce qui produit les coefficients h2(n);
> d) exploiter le filtre avec les nouveaux coefficients h2(n) à fa1.

**2.** Procédé de calcul des coefficients d'un filtre numérique non récursif en vue du décalage de la réponse en fréquence de ce filtre d'une fréquence caractéristique fc1 à une autre fréquence caractéristique fc2, **caractérisé par** les étapes suivantes :

> a) spécifier ou calculer les coefficients h1(n) d'un prototype du filtre pour une fréquence d'échantillonnage fa1 donnée;

> b) à partir des coefficients h1(n), calculer les nouveaux coefficients h2(n), en interpolant les valeurs de la réponse impulsionnelle h(t) continue dans le temps avec l'intervalle 1/fa2, où fa2 = fa1 * $\frac{fc1}{fc2}$;

> c) exploiter le filtre avec les nouveaux coefficients h2(n) à fa1.

**3.** Procédé selon la revendication 2, **caractérisé en ce que** des polynômes sont utilisés pour l'interpolation.

**4.** Procédé selon la revendication 3, **caractérisé en ce que** seuls des polynômes de degré 0 à 3 sont utilisés.

**5.** Procédé selon l'une quelconque des revendications 2 à 4, **caractérisé en ce que** le filtre continu dans le temps est échantillonné en partant du centre temporel.

**6.** Procédé selon la revendication 5, **caractérisé en ce que** pour un prototype de filtre avec N coefficients h1(n), avec n = 0, 1, ..., N-1, est interpolé aux endroits .

$$t = \frac{N - 1}{2 * fa1} + \frac{k}{fa2} \text{ avec } k = 0; +/-1; +/-2; ...,$$

k étant incrémenté ou décrémenté jusqu'à ce que tous les coefficients h1(n) utilisés pour l'interpolation respective présentent la valeur 0.

**7.** Procédé selon la revendication 6, **caractérisé en ce que** seuls les coefficients avec k = 0; +1; +2 ... sont calculés puisque les coefficients avec k négatif correspondent aux coefficients avec k positif.

**8.** Procédé selon l'une quelconque des revendications 1 à 7, **caractérisé en ce que** les nouveaux coefficients h2(n) sont multipliés par les valeurs d'échantillonnage d'une fonction sinus ou cosinus d'une fréquence fo.

## FIG 1

## FIG 2